(19) Europäisches Patentamt
European Patent Office
Office européen des brevets

(11) **EP 1 883 251 A1**

(12) **EUROPEAN PATENT APPLICATION**
published in accordance with Art. 153(4) EPC

(43) Date of publication:
**30.01.2008 Bulletin 2008/05**

(51) Int Cl.:
***H04N 17/00*** (2006.01)

(21) Application number: **06746653.2**

(22) Date of filing: **19.05.2006**

(86) International application number:
**PCT/JP2006/309997**

(87) International publication number:
**WO 2006/123768 (23.11.2006 Gazette 2006/47)**

(84) Designated Contracting States:
**DE FR GB**

(30) Priority: **19.05.2005 JP 2005146866**

(71) Applicant: **MATSUSHITA ELECTRIC INDUSTRIAL CO., LTD.**
**Osaka 571-8501 (JP)**

(72) Inventor: **YOSHIOKA, Kenji**
**Matsushita El.Ind.Co.,Ltd,Int.Prop.**
**Chuo-ku**
**Osaka-shi**
**Osaka 540-6319 (JP)**

(74) Representative: **Pautex Schneider, Nicole Véronique et al**
**Novagraaf International SA**
**25, Avenue du Pailly**
**1220 Les Avanchets - Geneva (CH)**

(54) **ABNORMALITY DETECTING APPARATUS**

(57) It is an object of the present invention to provide an error detecting apparatus that can diagnose what is happening with the line through which the image signal is passed, and determine a cause of trouble when the line diagnosed as going out of order. The error detecting apparatus comprises an error detecting circuit **11** for detecting a direct voltage from an output line through which an image signal is outputted to a display apparatus from an image signal outputting apparatus, and a CPU **10,** wherein a zener voltage of a zener diode **ZD** is within a first range, the CPU **10** is adapted to make a decision that the output line is in the output-line-to-power-line short state when a voltage of a cathode of a zener diode **ZD** is within the first range, a voltage of the electric potential regulated by a pull-up circuit **(D4** and **R8)** is within a second range, the CPU **10** is adapted to make a decision that the output line is in the electrically-disconnected state when the voltage of the output line is within the second range, an output voltage of a smoothing **circuit (C2** and **D1)** is within a third range, the CPU **10** is adapted to make a decision that the output line is in the normal state when the output voltage of the smoothing circuit is within the third range, a reference potential defined by a ground line is within a fourth range, the CPU **10** is adapted to make a decision that the output line is in the output-line-to-ground-line short state.

FIG. 2

**Description**

TECHNICAL FIELD OF THE INVENTION

This invention relates to an error detecting apparatus for detecting whether or not an image signal is being normally passed through a line.

DESCRIPTION OF THE RELATED ART

Up until now, there have been proposed a wide variety of error detecting apparatuses of this type, one typical example of which is disclosed in a patent document 1. The above-mentioned error detecting apparatus is adapted to judge whether or not parallel lines go out of order by judging whether or not parallel signals are being normally passed through the parallel lines as a coded image signal, and to make a decision that the parallel lines go out of order when at least one of the parallel lines is electrically-disconnected or short-circuited.

Patent document **1**: Jpn. unexamined patent publication No. H08-19007

DISCLOSURE OF THE INVENTION

PROBLEMS TO BE SOLVED BY THE INVENTION

The conventional error detecting apparatus, however, encounters such a problem that, even if those lines is diagnosed as going out of order, the conventional error detecting apparatus cannot diagnose which line is electrically-disconnected, or short-circuited.

It is, therefore, an object of the present invention to provide an error detecting apparatus that can diagnose what is happening with the line through which the image signal is passed.

MEANS FOR SOLVING THE PROBLEMS

The error detecting apparatus according to the present invention comprises: line condition judging means for judging, on the basis of a direct voltage obtained from an output line through which an image signal is outputted to a display apparatus from an image signal outputting apparatus, whether or not the output line is in a normal state, whether or not the output line is in an electrically-disconnected state, whether or not the output line is in an output-line-to-power-line short state, and whether or not the output line is in an output-line- to-ground-line short state.

The error detecting apparatus thus constructed as previously mentioned can diagnose the output line, and determine a cause of its trouble by reason that the judgment is made, on the basis of an electric potential of an output line through which an image signal is outputted to a display apparatus from an image signal outputting apparatus, whether or not the output line is in a normal state, whether or not the output line is in an electrically-disconnected state, whether or not the output line is in an output-line-to-power-line short state, and whether or not the output line is in an output-line-to-ground-line short state.

The line condition judging means may include a zener diode having a cathode corresponding to the output line, and an anode electrically connected to a ground line. The line condition judging means may be adapted to make a decision that the output line is in the output-line-to-power-line short state when an electric potential of the cathode is the same as a zener voltage defined by the zener diode, or within predefined limits.

The line condition judging means may include a pull-up circuit for regulating an electric potential of the output line by intervening between the output line and a power line. The line condition judging means may be adapted to make a decision that the output line is in the electrically-disconnected state when the regulated electric potential of the output line is within predefined limits.

The line condition judging means may include a smoothing circuit for smoothing the image signal. The line condition judging means may be adapted to make a decision that the output line is in the normal state when an output voltage of the smoothing circuit is within predefined limits.

The line condition judging means may be adapted to make a decision that the output line is in the output-line-to-ground-line short state when the electric potential of the output line is the same as a reference potential of a ground line, or within predefined limits.

ADVANTAGEOUS EFFECT OF THE INVENTION

The present invention has an advantageous effect of diagnosing what is happening with the line through which the image signal is passed, and determine a cause of its trouble when the line diagnosed as going out of order.

BRIEF DESCRIPTION OF THE DRAWINGS

FIG. **1** is a block diagram showing an image signal processing apparatus provided with an error detecting apparatus according to the embodiment of the present invention.
FIG. **2** is a circuit diagram showing, as an example, a circuit constituted as the error detecting apparatus according to the embodiment of the present invention.

EXPLANATION OF THE REFERENCE NUMERALS

| | |
|---|---|
| **1:** | image signal processing apparatus |
| **2:** | camera |
| **3:** | external apparatus for outputting an image signal |
| **4:** | display apparatus |
| **10:** | CPU |
| **11:** | diagnosis apparatus |
| **12:** | first image signal buffer |
| **13:** | sync separation circuit |
| **14:** | video processing apparatus |
| **15:** | second image signal buffer |
| **16:** | image signal selecting switch |
| **17:** | video amplifier |
| **18:** | DRAM |
| **19:** | flash memory |
| **20:** | diagnosis memory |
| **30:** | amplifier |
| **R6, R7, R8,** and **R9:** | resister |
| **C1, C2,** and **C3:** | capacitor |
| **D1, D2, D3,** and **D4:** | diode |
| **ZD:** | zener diode |

DESCRIPTION OF THE PREFERRED EMBODIMENTS

The embodiment of the error detecting apparatus according to the present invention will be described hereinafter with reference to accompanying drawings. The following description will be directed to the error detecting apparatus forming part of an in-vehicle image signal processing apparatus for receive an image signal from a camera, a picture receiver, or other external apparatus, and outputting the image signal to a display apparatus.

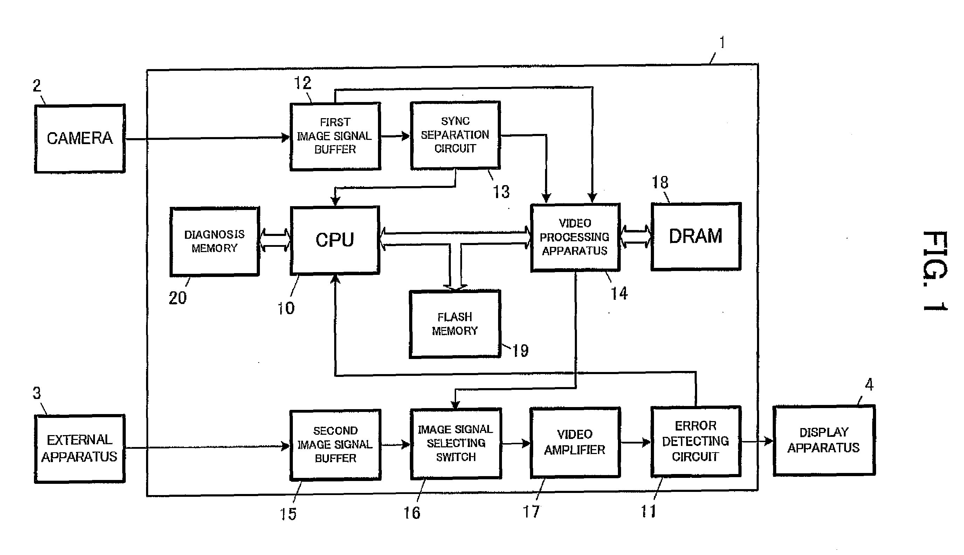

FIG. **1** is a block diagram showing an image signal processing apparatus provided with an error detecting apparatus according to the embodiment of the present invention.
The image signal processing apparatus 1 is electrically connected to a camera **2** for taking an image of an object behind an automotive vehicle, a navigation apparatus, an external apparatus **3** such as for example a television and a digital versatile disc (DVD) player, the external apparatus **3** being adapted to output an image signal to the image signal processing apparatus **1,** and a display apparatus **4** for displaying an image represented by an image signal processed by the image signal processing apparatus **1.**
The camera **2** includes a lens unit for providing an image of an object, and a charge-coupled device (CCD) for producing an image signal indicative of the image. Here, the image signal may be exemplified by a composite video signal, a RGB signal, a YUV signal, or a signal based on another format.
The display apparatus **4** has a screen, and constituted by a cathode ray tube, a liquid crystal display device or the like. The display apparatus 4 is adapted to display the image on the screen.
The image signal processing apparatus **1** comprises a central processing unit (CPU) **10,** a first image signal buffer **12** for buffering the image signal received from the camera **2,** a sync separation circuit **13** for obtaining a sync signal from the image signal received from the camera **2,** an video processing apparatus **14** for processing the image signal, a second image signal buffer **15** for buffering the image signal received from the external apparatus **3,** an image signal selecting switch **16** for selectively outputting the image signal processed by the video processing apparatus **14** and the image signal received from the external apparatus **3,** a video amplifier **17** for amplifying the image signal received from the image signal selecting switch **16,** and outputting the amplified image signal to the display apparatus 4 through an output line, an error detecting circuit **11** for judging whether or not the image signal is being normally outputted to the display apparatus **4** from the video amplifier **17** through the output line, a dynamic random access memory (DRAM) **18,** a flash memory **19,** a diagnosis memory **20** for storing, as diagnosis information, the judgment made by the error detecting circuit **11,** and a power supply unit (not shown) for supplying an electric power to each part of the image signal processing apparatus **1** and the camera **2.**

When the output line is diagnosed as being in "normal state", the image signal is being normally outputted to the display apparatus **4** through the output line. When the output line is diagnosed as being in "electrically-disconnected state", the image signal processing apparatus 1 is not being electrically connected to the display apparatus **4** through the output line without normally outputting the image signal to the display apparatus **4.** When the output line is diagnosed as being in "output-line-to-power-line short state", the output line is being directly connected to a power line, and equal in electric potential to the power line. When the output line is diagnosed as being in "output-line-to-ground-line short state", the output line is directly connected to a ground line, and equal in electric potential to the ground line.

The CPU **10** is adapted to load a program stored in a read only memory (not shown) into the DRAM **18,** and to control the video processing apparatus **14,** the image signal selecting switch 16, the power supply unit, and the like by executing the program loaded into the DRAM **18.**

The first image signal buffer **12** is adapted to buffer the image signal received from the camera **2,** and to regulate its pedestal (as a standard of brightness).

The sync separation circuit **13** is adapted to obtain a sync signal from the image signal buffered by the first image signal buffer **12,** while the CPU **10** is adapted to monitor the period of the sync signal obtained by the sync separation circuit 13, to judge whether or not the period of the sync signal is within predetermined limits, and to make a decision that the output line is not in the normal state when the sync signal is not within the limits.

The video processing apparatus **14** is constituted by a digital signal processing apparatus such as for example an image processor, while the CPU **10** is adapted to have the video processing apparatus **14** perform overhead-view processing of the image signal buffered by the first image signal buffer **12,** and perform superimposing processing of support information.

More specifically, the CPU **10** is adapted to compensate the distortion of the image taken at short range by performing the overhead-view processing, and to produce an image equivalent to a view from a position above the level of the camera **2,** the object being close to a bumper or other part of the automotive vehicle, and to superimpose support information on the image by performing the superimposing processing of the support information, the support information including information on a traveling direction of the automotive vehicle, a distance between the object and the automotive vehicle, and the like.

The second image signal buffer **15** is adapted to buffer the image signal received from the external apparatus **3,** and to regulate its pedestal (as a standard of brightness).

The CPU **10** is adapted to have the image signal selecting switch **16** selectively output the image signal processed by the video processing apparatus **14** and the image signal received from the external apparatus 3 to the video amplifier **17.**

The video amplifier **17** is adapted to amplify the image signal received from the image signal selecting switch **16** to ensure that the amplified image signal meets the requirements of the display apparatus **4.**

The error detecting circuit **11** and the CPU **10** are collectively constituted as line condition judging means of the error detecting apparatus according to the present invention. The error detecting circuit **11** includes capacitors **C1** to **C3,** an amplifier **30,** resisters **R6** to **R9,** diodes **D1** and **D2,** and a zener diode **ZD.**

The capacitor **C1** has one end electrically connected to an output terminal of the video amplifier **17,** and the other end electrically connected to an input terminal of the amplifier **30.** The resister **R6** has one end electrically connected to an output terminal of the amplifier **30,** and the other end electrically connected to one end of the capacitor **C2.**

The diode **D1** has a cathode electrically connected to the other end of the capacitor **C2,** an anode grounded. The capacitor **C2** and the diode **D1** are collectively constituted as a smoothing circuit. The diode D2 has an anode electrically connected to the other end of the capacitor C2, i.e., an output terminal of the smooth circuit.

The resister **R7** has one end electrically connected to the output terminal of the video amplifier **17,** and the other end electrically connected to the anode of the diode **D3.** The zener diode **ZD** has a cathode electrically connected to the other end of the resister **R7,** and an anode grounded. When the output line is in the output-line-to-power-line short state, the zener diode **ZD** is adapted to prevent the CPU **10** from giving rise to a latch-up phenomenon by preventing a voltage larger than a zener voltage of the zener diode **ZD** from being applied to the CPU **10.**

The diodes **D2** and **D3** have respective cathodes electrically connected to each other, and electrically connected to the CPU **10.** The diodes **D2** and **D3** collectively constitute a logical OR operation circuit. Each of the capacitor C3 and the resister R9 has one end electrically connected to the cathodes of the diodes D2 and D3, and the other end grounded.

The output terminal of the video amplifier **17** is electrically connected to an input terminal of the display apparatus **4** through the output line regulated in electric potential by a pull-up circuit including a diode **D4** and a register **R8**. The diode **D4** has a cathode electrically connected to the power line and an anode electrically connected to one end of the resister **R8**.

As shown in FIG. **1,** the DRAM **18** is electrically connected to the video processing apparatus **14,** and has, in addition to the program to be executed by the CPU **10,** temporary data to be used in a processing stage by the video processing apparatus **14**. The flash memory **19** is electrically connected to the video processing apparatus **14,** and has parameter and the like to be used by the video processing apparatus **14**.

The diagnosis memory **20** is constituted by a nonvolatile memory medium such as for example an electrically erasable programmable read-only memory (EEPROM). The CPU **10** is adapted to store diagnostic information in the diagnosis memory **20**. The diagnostic information includes, as current and previous diagnosis records, time, condition detected at each time, and the like.

The CPU **10** is adapted to output the diagnostic information stored in the diagnosis memory 20 to an interface circuit (not shown) for performing communication with a removable memory medium, or another apparatus.

The CPU **10** is adapted to have the power supply unit adjust the electric potential of the power line by stepping up or stepping down a supply voltage of a power source of the automotive vehicle, to have the power supply unit supply an electric power to each part of the image signal processing apparatus **1** and camera **2** through the power line. In order to prevent the CPU **10** or the camera **2** from falling into a latch-up state, the power supply unit is adapted not to supply the electric power to the CPU 10 and the camera **2** when the CPU **10** is not active.

The operation of the image signal processing apparatus **1** thus constructed will be then described hereinafter.

When a driver firstly turns on an ignition power source and an accessory power source of the automotive vehicle, the power supply unit supplies an electric power to each part of the image signal processing apparatus **1** to allow each part of the image signal processing apparatus **1** to be in an active state.

When a driver does not need the image of the object behind the automotive vehicle, for example, the automotive vehicle is not in a reverse gear, the image signal received from the external apparatus **3** is selected by the image signal selecting switch **16**. The image signal received from the external apparatus **3** is inputted into the video amplifier **17** through the second image signal buffer **15** and the image signal selecting switch **16.**

When, on the other hand, the driver needs the image of the object behind the automotive vehicle, for example, the automotive vehicle is in the reverse gear, the electric power is supplied to the camera **2** from the power supply unit in order to turn on the camera. The image signal processed by the video processing apparatus **14** is selected by the image signal selecting switch **16**. The image signal received from the external apparatus **3** is inputted into the video amplifier **17** through the second image signal buffer **15** and the image signal selecting switch 16.

The image signal received from the camera **2** is inputted into the video processing apparatus **14** through the first image signal buffer **12**. The image signal received from the first image signal buffer **12** is then processed by the video processing apparatus **14**. The image signal processed by the video processing apparatus **14** is then outputted to the video amplifier **17** through the image signal selecting switch **16.**

The image signal is received from the image signal selecting switch **16** by the video amplifier **17,** amplified by the video amplifier **17,** and outputted to the display apparatus **4**. The image represented by the amplified image signal is then displayed on the screen by the display apparatus.

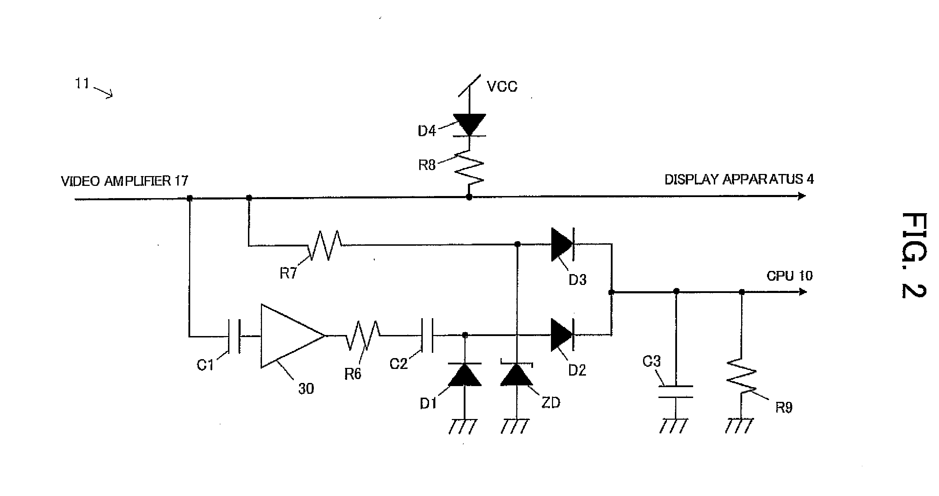

The operation of the error detecting circuit **11** will be then described hereinafter with reference to FIG **2.** In this embodiment, a direct voltage "VCC" of the power line to the ground line is equal to 3.3 [volt], and a forward voltage drop "Vd" of the diode **D4** is equal to 0.6 [volt]. The resisters **R6**, **R7**, **R8**, and **R9** have respective resistances of 1 [kilo ohm], 4.7 [kilo ohm], 22 [kilo ohm], and 100 [kilo ohm]. The capacitors **C1**, **C2**, and **C3** have respective capacitances of 1 [micro farad], 2.2 [micro farad], and 1 [micro farad].

When the output line is in the output-line-to-power-line short state, the electric potential of the anode of the diode D3 to the ground line is suppressed to 3.3 [volt] by the zener diode ZD in this embodiment.

From the foregoing description, it will be understood that the potential difference suppressed to 3.3 [volt] is inputted into the CPU **10** when the output line is in the output-line-to-power-line shout state.

When the in-vehicle image signal processing apparatus **1** is being electrically-disconnected to the display apparatus **4** without normally outputting the image signal to the display apparatus **4,** a voltage corresponding to the register **R9** is given by a follow equation by reason that the pull-up circuit intervenes between the output line and the power line, and includes a diode **D4** and a resister **R8**, and a voltage difference between the direct voltage "VCC" and the forward voltage drop "Vd" is being divided by the resisters **R7, R8,** and **R9**.

$$(\mathrm{VCC} - \mathrm{Vd}) \times \mathbf{R9} \div (\mathbf{R7} + \mathbf{R8} + \mathbf{R9}) \; \fallingdotseq \; 2.1 \; [\mathrm{volt}]$$

From the foregoing description, it will be understood that the image signal suppressed to 2.1 [volt] is inputted into the CPU 10 when the output line is in the electrically-disconnected state.

When the image signal is being normally outputted to the display device **4** through the output line, the voltage to be detected by the CPU **10** is dependent on a signal outputted from the amplifier **30,** and hardly affected by other elements (such as a pull-up circuit for regulating in electric potential the output line) by reason that the display apparatus **4** has an input impedance of 75 [ohm], and electrically connected to the video amplifier **17** through the output line.

Here, the amplifier **30** has a gain to be adjusted on the basis of a median of the image signal smoothed by a smoothing circuit (constituted by the capacitor **C2** and the diode **D1).** The amplifier **30** is adapted to amplify the image signal according to the adjusted gain to ensure that the median of the smoothed image signal is approximately equal to 1 [volt].

From the foregoing description, it will be understood that the image signal suppressed to about 1 [volt] is inputted into the CPU **10** when the output line is in the normal state.

When the output line is in the output-line-to-ground-line short state, the image signal is suppressed to zero [volt], i.e., a reference potential. Accordingly, the image signal suppressed to zero [volt] is inputted into the CPU **10.**

From the foregoing description, it will be understood that the CPU 10 can make a decision that the output line is in the output-line-to-power-line short state when the voltage obtained from the error detecting circuit **11** is no less than 2.7 [volt], make a decision that the output line is in the electrically-disconnected state when the voltage obtained from the error detecting circuit **11** is smaller than 2.7 [volt], and no less than 1.6 [volt], make a decision that the output line is in the normal state when the voltage obtained from the error detecting circuit **11** is smaller than 1.6 [volt], and no less than 0.5 [volt], and make a decision that the output line is in the output-line-to-ground-line short state when the voltage obtained from the error detecting circuit **11** is smaller than 0.5 [volt].

From the foregoing description, it will be understood that the image signal processing apparatus **1** according to the embodiment of the present invention can obtain, when the output line goes out of order, diagnosis outcome such as a cause of trouble from the error detecting apparatus **11** by reason that the error detecting apparatus **11** is adapted to judge, on the basis of the voltage obtained from the error detecting circuit **11** by the CPU **10,** whether or not the line is in the normal state, whether or not the line is in the electrically-disconnected state, whether or not the line is in the output-line-to-power-line short state, and whether or not the line is in the output-line-to-ground-line short state, and determine a cause of trouble when the line diagnosed as going out of order.

INDUSTRIAL APPLICABILITY OF THE PRESENT INVENTION

As will be seen from the foregoing description, the error detecting apparatus according to the present invention has an advantageous effect of monitoring the line through which the image signal is passing, and diagnosing what is happening with the line. The error detecting apparatus according to the present invention is useful as, for example, an apparatus for determining a cause of trouble when the line diagnosed as going out of order.

**Claims**

1. An error detecting apparatus, comprising: line condition judging means for judging, on the basis of a direct voltage obtained from an output line through which an image signal is outputted to a display apparatus from an image signal outputting apparatus, whether or not said output line is in a normal state, whether or not said output line is in an electrically-disconnected state, whether or not said output line is in an output-line-to-power-line short state, and whether or not said output line is in an output-line-to-ground-line short state.

2. An error detecting apparatus as set forth in claim 1, in which said line condition judging means includes a zener diode having a cathode corresponding to said output line, and an anode electrically connected to a ground line, and in which said line condition judging means is adapted to make a decision that said output line is in said output-line-to-power-line short state when an electric potential of said cathode is the same as a zener voltage defined by said zener diode, or within predefined limits.

3. An error detecting apparatus as set forth in claim 1, in which said line condition judging means includes a pull-up circuit for regulating an electric potential of said output line by intervening between said output line and a power line, and in which
said line condition judging means is adapted to make a decision that said output line is in said electrically-disconnected state when said regulated electric potential of said output line is within predefined limits.

4. An error detecting apparatus as set forth in claim 1, in which said line condition judging means includes a smoothing circuit for smoothing said image signal, and in which
said line condition judging means is adapted to make a decision that said output line is in said normal state when an output voltage of said smoothing circuit is within predefined limits.

5. An error detecting apparatus as set forth in claim 1, in which said line condition judging means is adapted to make a decision that said output line is in said output-line-to-ground-line short state when said electric potential of said output line is the same as a reference potential of a ground line, or within predefined limits.

6. An error detecting apparatus, comprising: line condition judging means for judging, on the basis of an electric potential of an output line through which an image signal is outputted to a display apparatus from an image signal outputting apparatus, whether or not said output line is in a normal state, whether or not said output line is in an electrically-disconnected state, whether or not said output line is in an output-line-to-power-line short state, and whether or not said output line is in an output-line-to-ground-line short state, wherein
said line condition judging means includes a zener diode having a cathode corresponding to said output line, and an anode electrically connected to a ground line, a zener voltage of said zener diode being within a first range, a pull-up circuit for regulating an electric potential of said output line by intervening between said output line and a power line, and a smoothing circuit for smoothing said image signal,
said line condition judging means is adapted to make a decision that said output line is in said output-line-to-power-line short state when an electric potential of said cathode is the same as a zener voltage defined by said zener diode, or within predefined limits,
said line condition judging means is adapted to make a decision that said output line is in said electrically-disconnected state when said regulated electric potential of said output line is within predefined limits,
said line condition judging means is adapted to make a decision that said output line is in said normal state when an output voltage of said smoothing circuit is within predefined limits, and
said line condition judging means is adapted to make a decision that said output line is in said output-line-to-ground-line short state when said image signal is the same as a reference potential of said ground line, or within predefined limits.

7. A video system, comprising:

an image signal outputting apparatus for outputting an image signal;
a display apparatus for displaying an image represented by said image signal; and
an image signal processing apparatus for allowing said display apparatus to display said image on a screen, said image being represented by said image signal received from said image signal outputting apparatus, wherein said image signal processing apparatus has line condition judging means for judging, on the basis of an electric potential of an output line through which an image signal is outputted to a display apparatus from an image signal outputting apparatus, whether or not said output line is in a normal state, whether or not said output line is in an electrically-disconnected state, whether or not said output line is in an output-line-to-power-line short state, and whether or not said output line is in an output-line-to-ground-line short state.

# FIG. 1

# FIG. 2

**INTERNATIONAL SEARCH REPORT**

| International application No. |
| --- |
| PCT/JP2006/309997 |

A. CLASSIFICATION OF SUBJECT MATTER
*H04N17/00*(2006.01)

According to International Patent Classification (IPC) or to both national classification and IPC

B. FIELDS SEARCHED

Minimum documentation searched (classification system followed by classification symbols)
H04N17/00

Documentation searched other than minimum documentation to the extent that such documents are included in the fields searched
Jitsuyo Shinan Koho        1922-1996   Jitsuyo Shinan Toroku Koho   1996-2006
Kokai Jitsuyo Shinan Koho  1971-2006   Toroku Jitsuyo Shinan Koho   1994-2006

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y | JP 2001-153957 A  (General Electric Co.), 08 June, 2001 (08.06.01), Par. No. [0019] & US 6407770 B1          & EP 1088516 A2 | 1-7 |
| Y | JP 2000-020900 A  (Hitachi, Ltd.), 21 January, 2000 (21.01.00), Par. No. [0063] (Family: none) | 1-7 |
| Y | JP 09-331219 A  (Sanyo Electric Co., Ltd.), 22 December, 1997 (22.12.97), Par. No. [0005] (Family: none) | 2,6 |

☒ Further documents are listed in the continuation of Box C.        ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
| --- | --- |
| 16 June, 2006 (16.06.06) | 27 June, 2006 (27.06.06) |

| Name and mailing address of the ISA/ Japanese Patent Office | Authorized officer |
| --- | --- |
| Facsimile No. | Telephone No. |

Form PCT/ISA/210 (second sheet) (April 2005)

**INTERNATIONAL SEARCH REPORT**

| International application No. |
| --- |
| PCT/JP2006/309997 |

C (Continuation).    DOCUMENTS CONSIDERED TO BE RELEVANT

| Category* | Citation of document, with indication, where appropriate, of the relevant passages | Relevant to claim No. |
| --- | --- | --- |
| Y | WO 2004/036748 A2   (KONINKLIJKE PHILIPS ELECTRONICS N.V.), 29 April, 2004 (29.04.04), Page 5, lines 1 to 14 (Family: none) | 3,6 |
| Y | JP 05-137316 A   (NEC Home Electronics Ltd.), 01 June, 1993 (01.06.93), Page 2, right column, lines 21 to 26 (Family: none) | 4,6 |
| P,Y | JP 2006-504299 A   (KONINKLIJKE PHILIPS ELECTRONICS N.V.), 02 February, 2006 (02.02.06), Par. Nos. [0022], [0023] (Family: none) | 1-7 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H0819007 B